# EUROPEAN PATENT APPLICATION

(11) **EP 4 492 462 A1**
(43) Date of publication of application: **15.01.2025**
(21) Application number: 24187649.9
(22) Date of filing: 10.07.2024
(51) Int. Cl.: H01L 25/075, H01L 33/62

(54) **LIGHT EMITTING MODULE AND LIGHT EMITTING SYSTEM INCLUDING THE SAME**

(30) Priority: 14.07.2023 US 202363526732 P; 14.08.2023 US 202363532458 P; 30.04.2024 US 202463640577 P; 09.07.2024 US 202418767170
(71) Applicant: Seoul Semiconductor Co., Ltd., Gyeonggi-do 15429 (KR)
(72) Inventor: PARK, Inheum, 15429 Ansan-si (KR)
(74) Representative: Stolmár & Partner Patentanwälte PartG mbB

(57) **Abstract**

A light emitting module is disclosed. The light emitting module includes: a light transmissive layer transmitting light; and a film disposed on at least one surface of the light transmissive layer, wherein the film comprises a plurality of light emitting devices, and the light emitting module displays at least one of shapes, characters, emoticons, or pictures through the plurality of light emitting devices while maintaining transparency when the plurality of light emitting devices is not turned on.

## Description

### [Technical Field]

Embodiments of the present disclosure relate to a light emitting module realizing colors and a light emitting system including the same.

### [Background Art]

A light emitting diode (LED) is one of a light emitting devices that emits light upon application of current thereto. The light emitting diode is formed by growing epitaxial layers on a substrate and includes an N-type semiconductor layer, a P-type semiconductor layer, and an active layer interposed therebetween. An N-electrode pad is formed on the N-type semiconductor layer and a P-electrode pad is formed on the P-type semiconductor layer such that the light emitting diode is electrically connected to and driven by an external power source through the electrode pads. Here, current flows from the P-electrode pad to the N-electrode pad through the semiconductor layers.

Meanwhile, in order to prevent light loss due to the P-electrode pad while improving heat dissipation, flip-chip structure light emitting diodes are used and various electrode structures are proposed to assist in current distribution in large flip-chip light emitting diodes. By way of example, a reflective electrode may be formed on the P-type semiconductor layer and a region of the N-type semiconductor layer exposed by etching the P-type semiconductor layer and the active layer may be formed with extensions for current distribution.

### [Disclosure]

### [Technical Problem]

Embodiments of the present disclosure provide a light emitting module configured to realize shapes, characters, and the like on a board having light transmittance, such as glass and the like, and a light emitting system including the same.

Exemplary embodiments of the present invention provide a light emitting device that can reduce light loss while improving light extraction efficiency.

Exemplary embodiments of the present invention provide a light emitting device that can delay moisture penetration while improving reliability through increase in length of a moisture penetration path.

Exemplary embodiments of the present invention provide a light emitting device that can improve light output.

Exemplary embodiments of the present invention provide a light emitting device that improves light quality.

Exemplary embodiments of the present invention provide a light emitting device that has high color purity.

### [Technical Solution]

In accordance with one or more embodiments of the present disclosure, a light emitting apparatus may include: a light transmissive layer; a base film disposed on at least one surface of the light transmissive layer; an electrode layer disposed on at least one surface of the base film; and a plurality of light emitting devices disposed on at least one surface of the base film and electrically connected to the electrode layer, wherein the plurality of light emitting devices maintains a light transmittance of 70% or more when not turned on.

The electrode layer may cover 50% or less of an extent of the base film.

The base film and the light transmissive layer may have different transmittance. wherein a measured luminous intensity that pass through the base film may be higher than a measured luminous intensity that pass though the light transmissive layer.

The light transmissive layer may include a plurality of layers having different indexes of refraction.

A region of the light transmissive layer may have a translucent region.

The base film may include an electrode for supplying current to the plurality of light emitting devices, wherein the electrode may be formed as a mesh-shape thin plate.

At least two or more of the plurality of light emitting devices may be disposed in regular intervals from each other.

At least two or more of the plurality of light emitting devices may be disposed in different intervals in a region of the base film.

The base film and the light transmissive layer may differ from each other in terms of at least one of an index of refraction, gloss, thermal conductivity, or electrical conductivity.

The base film may have a light transmittance of 50% or more.

The electrode may extend to a rim of the light transmissive layer to be connected to an external power source.

The electrode may cover 50% or less of a total surface of the base film.

The plurality of light emitting devices may be configured to be individually operated or may be divided into individually operated different regions.

A distance between adjacent light emitting devices of the plurality of light emitting devices may be greater than a length or width of each of the respective light emitting devices.

The light emitting apparatus may further include a light transmissive layer disposed on one surface of the base film, wherein a measured luminous intensity that pass through the light transmissive layer may be higher than a measured luminous intensity that pass through the base film.

The base film may be further provided with an absorption region in a region thereof, wherein luminous intensity of light emitted through the absorption region may be lower than luminous intensity of light emitted through the base film outside of the absorption region.

In accordance with one or more embodiments of the present disclosure, a light emitting apparatus may include a base film; an electrode layer disposed on a region of the base film; a plurality of light emitting devices disposed on a region of the base film and electrically connected to the electrode layer; and a light transmissive layer including a first light transmissive layer disposed on a first region of the base film and a second light transmissive layer disposed on a second region of the base film facing the first region of the base film, wherein the plurality of light emitting devices has a transmittance of 70% or more when not turned on, and wherein luminous intensity measured on a side of the first light transmissive layer may be different from luminous intensity measured on a side of the second light transmissive layer.

The first light transmissive layer and the second light transmissive layer may have different indices of refraction.

A region of the light transmissive layer may be subjected to translucent treatment. The electrode may cover 50% or less of a total area of the base film.

The base film may include an electrode for supplying current to the plurality of light emitting devices, wherein the electrode may be formed as a mesh-shaped thin plate.

The electrode may extend to a rim of the light transmissive layer to be connected to an external power source.

At least two or more of the plurality of light emitting devices may be disposed in regular intervals from each other.

At least two or more of the plurality of light emitting devices may be disposed in different intervals in a region thereof.

The base film and the light transmissive layer may differ from each other in terms of at least one of an index of refraction, gloss, thermal conductivity, or electrical conductivity.

The base film may have a light transmittance of 50% or more.

The plurality of light emitting devices may be configured to be individually operated or may be divided into individually operated different regions.

A distance between adjacent light emitting devices of the plurality of light emitting devices may be greater than a length or width of each of the respective light emitting devices.

The first light transmissive layer may have higher transmittance than the second light transmissive layer.

The light transmissive layer may include a heat conductive layer having high thermal conductivity on one surface thereof.

The light emitting apparatus may further include a light transmissive layer disposed on a region of the base film, wherein luminous intensity of light emitted through the light transmissive layer may be higher than luminous intensity of light emitted through the base film.

The base film may be further provided with an absorption region in a region thereof, wherein luminous intensity of light emitted through the absorption region may be lower than luminous intensity of light emitted through the base film outside of the absorption region.

In accordance one or more embodiments of the present disclosure, a light emitting apparatus may include: a light transmissive base film; an electrode layer disposed on a region of the base film; a plurality of light emitting devices disposed on the region of the base film and electrically connected to the electrode layer; a light transmissive layer disposed in at least a region of the base film; and a low transmittance layer disposed in at least a region of the base film.

The light transmissive layer may be formed on one surface of the base film and the low transmittance layer may be formed on another region of the base film to vertically overlap each other in at least a region in vertically cross-sectional view.

The low transmittance layer may have a transmittance of 50% or less.

Luminous intensity on the low transmittance layer may be 50% of luminous intensity on the light transmissive layer.

The low transmittance layer may include an additive and may have a higher concentration of the additive per unit area than the base film or the light transmissive layer.

At least two or more of the plurality of light emitting devices may be disposed in regular intervals from each other.

At least two or more of the plurality of light emitting devices may be disposed in different intervals in a region thereof.

The base film and the light transmissive layer may differ from each other in terms of at least one of an index of refraction, gloss, thermal conductivity, or electrical conductivity.

The base film may have a light transmittance of 50% or more.

The electrode may extend to a rim of the light transmissive layer to be connected to an external power source.

The electrode may cover 50% or less of a total area of the base film.

The plurality of light emitting devices may be configured to be individually operated or may be divided into different regions and individually operated.

A distance between adjacent light emitting devices of the plurality of light emitting devices may be greater than a length or width of each of the respective light emitting devices.

The light transmissive layer may include a first light transmissive layer and a second light transmissive layer, wherein the first light transmissive layer has higher transmittance than the second light transmissive layer.

The light transmissive layer may include a heat conductive layer having high thermal conductivity on one surface thereof.

The light emitting apparatus may further include a light transmissive layer disposed on a region of the base film, wherein a measured luminous intensity that pass through the light transmissive layer may be higher than a measured luminous intensity that pass through the base film.

The base film may be further provided with an absorption region in a region thereof, wherein luminous intensity of light emitted through the absorption region may be lower than luminous intensity of light emitted through the base film outside of the absorption region.

In accordance with one or more embodiments aspect of the present disclosure, a light emitting apparatus may include: a light transmissive base film; an electrode layer disposed on a region of the base film; a plurality of light emitting devices disposed on the region of the base film and electrically connected to the electrode layer; a low transmittance layer disposed in at least a region of the base film; and a light transmissive layer disposed in at least a region of the base film and on one surface of the low transmittance layer.

The low transmittance layer may include an open region in a region of the base film.

The light transmissive layer may be spaced apart from the base film by the low transmittance layer in a region thereof.

Luminous intensity on the low transmittance layer may be 50% or less of luminous intensity on the light transmissive layer.

The low transmittance layer may include an additive and may have a higher concentration of the additive per unit area than the base film or the light transmissive layer.

The light transmissive layer may include regions having different transmittivity and spaced apart a predetermined distance from each other on an upper surface thereof. A measured luminous intensity on a first region of the light transmissive layer may be different form a measured luminous intensity on a second region of the light transmissive layer that spaced apart from the first region.

The plurality of light emitting devices may be disposed at different intervals in a region of the base film.

The base film and the light transmissive layer may differ from each other in terms of at least one of an index of refraction, gloss, thermal conductivity, or electrical conductivity.

The base film may have a light transmittance of 50% or more.

The electrode may extend to a rim of the light transmissive layer to be connected to an external power source.

The electrode may cover 50% or less of a total extent of the base film.

The plurality of light emitting devices may be configured to be individually operated or may be divided into individually-operated different regions.

A distance between adjacent light emitting devices of the plurality of light emitting devices may be greater than a length or width of each of the respective light emitting devices.

The light transmissive layer includes a first light transmissive layer disposed on upper region of the base film and a second light transmissive layer disposed on another region of the base film. Wherein the first light transmissive layer may have higher transmittance than the second light transmissive layer.

The light transmissive layer may include a heat conductive layer having high thermal conductivity on a region thereof.

The base film may be further provided with an absorption region in a region thereof, wherein luminous intensity of light emitted through the absorption region may be lower than luminous intensity of light emitted through the base film outside of the absorption region.

In accordance one or more embodiments aspect of the present disclosure, a light emitting apparatus may include: a base film; an electrode layer disposed on a region of the base film; a plurality of light emitting devices disposed on the region of the base film and electrically connected to the electrode layer; a first low transmittance layer disposed in at least a region of the base film; a second low transmittance layer disposed on another region of the base film; and a light transmissive layer disposed in at least a region of the base film and on a region of the first low transmittance layer.

The low transmittance layer may include an open region in a region of the base film.

The light transmissive layer may be spaced apart from the base film by the low transmittance layer in a region thereof.

Luminous intensity on the low transmittance layer may be 50% or less of luminous intensity on the light transmissive layer.

The low transmittance layer may include an additive and may have a higher concentration of the additive per unit area than the base film or the light transmissive layer.

The light transmission layer may include a region in which the first low light transmissive layer is not disposed and a region in which the first low light transmissive layer is disposed, wherein luminous intensity of light emitted through an upper surface of the light transmissive layer is different between the region in which the first low light transmissive layer is not disposed and the region in which the first low light transmissive layer is disposed.

Luminous intensity of light emitted from a region in which the first low transmittance layer is disposed may be different from luminous intensity of light emitted from a region in which the second low transmittance layer is disposed.

At least two or more of the plurality of light emitting devices may be disposed in different intervals in a region of the base film.

The base film and the light transmissive layer may differ from each other in terms of at least one of an index of refraction, gloss, thermal conductivity, or electrical conductivity.

The base film may have a light transmittance of 50% or more.

The electrode may extend to a rim of the light transmissive layer to be connected to an external power source.

The electrode may cover 50% or less of a total area of the base film.

The plurality of light emitting devices may be configured to be individually operated or may be divided into different individually-operated regions.

A distance between adjacent light emitting devices of the plurality of light emitting devices may be greater than a length or width of each of the respective light emitting devices.

The light transmissive layer may include a first light transmissive layer and a second light transmissive layer, and the first light transmissive layer may have higher transmittance than the second light transmissive layer.

The light transmissive layer may include a heat conductive layer having high thermal conductivity on one surface thereof.

The base film may be further provided with an absorption region in a region thereof, wherein luminous intensity of light emitted through the absorption region may be lower than luminous intensity of light emitted through the base film outside of the absorption region.

In accordance with one or more embodiments aspect of the present disclosure, a light emitting apparatus may include: a base film; an electrode layer disposed on a region of the base film; and a plurality of light emitting devices disposed on the region of the base film and electrically connected to the electrode layer; a first light transmissive layer disposed in at least a region of the base film; a second light transmissive layer disposed on another surface of the base film; a first low transmittance layer disposed on the first light transmissive layer and in a region of the base film; and a second low transmittance layer disposed on one surface of the second light transmissive layer.

The low transmittance layer may include an open region in a region of the base film.

The light transmissive layer may be spaced apart from the base film by the low transmittance layer in a region thereof.

Transmittivity on the low transmittance layer may be 50% or less of transmittivity on the light transmissive layer.

The low transmittance layer may include an additive and may have a higher concentration of the additive per unit area than the base film or the light transmissive layer.

At least a region of the base film may have different luminous intensity than another region of the base film facing the region of the base film.

The plurality of light emitting devices may be disposed at different intervals in a region ofthe base film.

The base film and the light transmissive layer may differ from each other in terms of at least one of an index of refraction, gloss, thermal conductivity, or electrical conductivity.

The base film may have a light transmittance of 50% or more.

The electrode may extend to a rim of the light transmissive layer to be connected to an external power source.

The electrode may cover 50% or less of a total extent of the base film.

The plurality of light emitting devices may be configured to be individually operated or may be divided into different individually-operated regions.

A distance between adjacent light emitting devices of the plurality of light emitting devices may be greater than a length or width of each of the respective light emitting devices.

The first light transmissive layer may have higher transmittance than the second light transmissive layer.

The light transmissive layer may include a heat conductive layer having high thermal conductivity on a region thereof.

The base film may be further provided with an absorption region in a region thereof, wherein luminous intensity of light emitted through the absorption region may be lower than luminous intensity of light emitted through the base film outside of the absorption region.

Luminous intensity of light emitted from a region in which the first low transmittance layer is disposed may be different from luminous intensity of light emitted from a region in which the second low transmittance layer is disposed.

The low transmittance layer may include an open region in a region of the base film.

Luminous intensity of light emitted from a region of the first light transmissive layer in which the first low transmittance layer is disposed may be different from luminous intensity of light emitted from the open region of the first low transmissive layer.

The light transmissive layer may be spaced apart from the base film by the low transmittance layer in a region thereof.

Luminous intensity on the low transmittance layer may be 50% or less of luminous intensity on the light transmissive layer.

The low transmittance layer may include an additive and may have a higher concentration of the additive per unit area than the base film or the light transmissive layer.

The light transmissive layer may include regions having different transmittivity and spaced apart a predetermined distance from each other on an upper surface thereof.

The plurality of light emitting devices may be disposed in different intervals in a region of of the base film.

The base film and the light transmissive layer may differ from each other in terms of at least one of an index of refraction, gloss, thermal conductivity, or electrical conductivity.

The base film may have a light transmittance of 50% or more.

The electrode may extend to a rim of the light transmissive layer to be connected to an external power source.

The electrode may cover 50% or less of a total extent of the base film.

The plurality of light emitting devices may be configured to be individually operated or may be divided into different individually-operated regions.

A distance between adjacent light emitting devices of the plurality of light emitting devices may be greater than a length or width of each of the respective light emitting devices.

The first light transmissive layer may have higher transmittance than the second light transmissive layer.

The light transmissive layer may include a heat conductive layer having high thermal conductivity on a region thereof.

In accordance with one or more embodiments of the present disclosure, a light emitting system may include: a base film; an electrode layer disposed on a region of the base film; a light emitting region including a plurality of light emitting devices disposed on the region of the base film and electrically connected to the electrode layer; a light transmissive layer disposed in at least a region of the base film; a low transmittance layer disposed in at least a region of the base film; and the light emitting system may be capable of displaying information required by a user.

The light emitting region may have a preset shape.

The light emitting region may be divided into separate individually-operated regions.

The low transmittance layer and the base film may be disposed to vertically overlap each other in at least a region thereof in vertically cross-sectional view.

The electrode may cover 50% or less of an extent of the base film.

The base film may be a dominant emission surface of light emitted from the light emitting devices and luminous intensity measured on one surface of the base film may be higher than luminous intensity measured on one surface of the light transmissive layer.

The light transmissive layer may include a plurality of layers having different indices of refraction.

A region of the light transmissive layer may be subjected to translucent treatment.

The base film may include an electrode for supplying current to the plurality of light emitting devices, wherein the electrode may be formed as a mesh-shaped thin plate.

At least two or more of the plurality of light emitting devices may be disposed in regular intervals from each other.

At least two or more of the plurality of light emitting devices may include a section with different intervals.

The base film and the light transmissive layer may differ from each other in terms of at least one of an index of refraction, gloss, thermal conductivity, or electrical conductivity.

The low transmittance layer may include an open region in a region thereof.

Luminous intensity of light emitted from a region of the light transmissive layer in which the low transmittance layer is disposed may be different from luminous intensity of light emitted from the open region of the low transmissive layer.

The light transmissive layer may be spaced apart from the base film by the low transmittance layer in a region thereof.

The base film may have a light transmittance of 50% or more.

The electrode may extend to a rim of the light transmissive layer to be connected to an external power source.

The electrode may cover 50% or less of a total extent of the base film.

The plurality of light emitting devices may be configured to be individually operated or may be divided into different individually-operated regions.

A distance between adjacent light emitting devices of the plurality of light emitting devices may be greater than a length or width of each of the respective light emitting devices.

The light emitting system may further include a light transmissive layer disposed on a region of the base film, wherein luminous intensity of light emitted through the light transmissive layer may be higher than luminous intensity of light emitted through the base film.

The base film may be further provided with an absorption region in a region thereof, wherein luminous intensity of light emitted through the absorption region may be lower than luminous intensity of light emitted through the base film outside of the absorption region.

### [Advantageous Effects]

A light emitting module according to the present disclosure and a light emitting system including the same can display certain shapes, characters, emoticons, pictures, and the like, only when needed, while maintaining transparency when light emitting devices thereof are not turned on.

Embodiments of the present disclosure provide a light emitting apparatus that maintains transparency to secure a visual field.

Embodiments of the present disclosure provide a light emitting apparatus with a reduced thickness to secure a space while increasing the degree of design freedom.

Embodiments of the present disclosure provide a light emitting apparatus that can reduce light loss while improving light extraction efficiency.

Embodiments of the present disclosure provide a light emitting apparatus that can delay moisture penetration while improving reliability through increase in length of a moisture penetration path.

Embodiments of the present disclosure provide a light emitting apparatus that improves visibility through adjustment of a light path using a low transmittance layer.

Embodiments of the present disclosure provide a light emitting apparatus that improves reliability and stability through improvement of a heat dissipation structure.

Embodiments of the present disclosure provide a light emitting apparatus that reduces glare by preventing light leakage.

### [Description of Drawings]

FIG. 1 is a schematic plan view of a light emitting module according to one embodiment of the present disclosure.
FIG. 2 is a schematic sectional view of one embodiment of the light emitting module taken along line A-A' in FIG. 1.
FIG. 3 is a schematic sectional view of another embodiment of the light emitting module taken along line A-A' in FIG. 1.
FIG. 4 is a schematic sectional view of a further embodiment of the light emitting module taken along line A-A' in FIG. 1.
FIG. 5 to FIG. 7 are schematic views of a light emitting system according to one embodiment of the present disclosure.
FIG. 8 is a schematic view of a light emitting system according to another embodiment of the present disclosure.
FIG. 9 is a schematic sectional view of one embodiment of the light emitting system taken along line B-B' in FIG. 8.
FIG. 10 is a schematic sectional view of another embodiment of the light emitting system taken along line B-B' in FIG. 8.

### [Detailed Description]

In the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. By way of example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. By way of example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. By way of example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. By way of example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hardwired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

Hereinafter, exemplary embodiments of the present disclosure will be described in more detail with reference to the accompanying drawings.

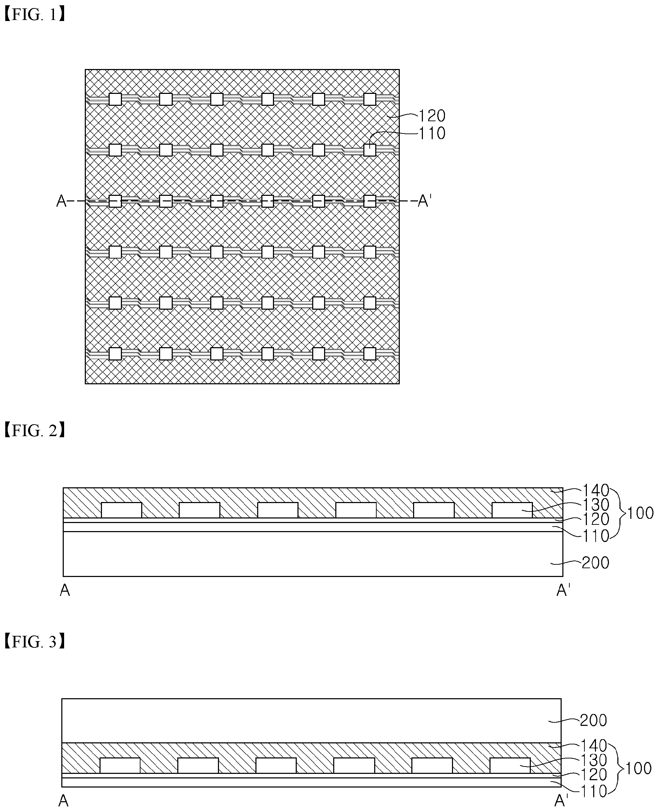

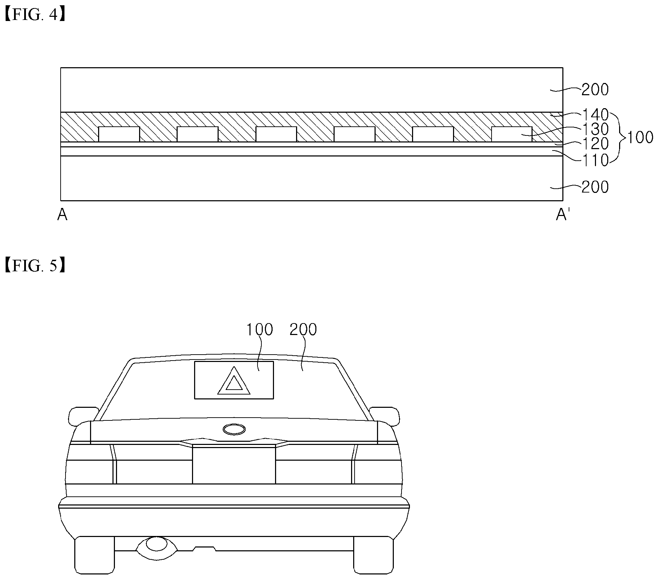

FIG. 1 is a schematic plan view of a light emitting module according to one embodiment of the present disclosure, FIG. 2 is a schematic sectional view of one embodiment of the light emitting module taken along line A-A' in FIG. 1, FIG. 3 is a schematic sectional view of another embodiment of the light emitting module taken along line A-A' in FIG. 1, and FIG. 4 is a schematic sectional view of a further embodiment of the light emitting module taken along line A-A' in FIG. 1.

Referring to FIG. 1 to FIG. 4, a light emitting module according to the present disclosure includes a film 100 and a light transmissive layer 200.

The light transmissive layer 200 is formed of a material that transmits light, and may include at least one of poly(methyl methacrylate) (PMMA) resins, polycarbonate (PC) resins, cycloolefin polymer (COP) resins, acryl resins, polyethylene (PE) resins, epoxy resins, glass, or quartz.

The light transmissive layer 200 may have a thickness of about 3 mm to 5 mm and may be thicker than light emitting devices 130. The light transmissive layer 200 may be composed of a single layer or a plurality of layers. By way of example, the light transmissive layer 200 may have a single layer structure, which provides a simpler light travel path, and may have higher transparency. Alternatively, the light transmissive layer 200 may also be a stack type light transmissive layer 200, in which two or more layers having different indices of refraction or transmittances are stacked. The stack type light transmissive layer 200 may have a structure in which a lower refractivity layer is stacked on a higher refractivity layer. By way of example, a light path may be corrected using a difference in index of refraction by stacking a lower refractivity layer having an index of refraction of 1.4 to 1.55 on a higher refractivity layer having an index of refraction of 1.6 or greater. In addition, the light transmissive layer may have a lower index of refraction than a light emitting surface of the light emitting device 130. Further, a plurality of layers with different transmittances may be stacked. By way of example, a region of the light transmissive layer may be subjected to translucent region treatment to have a transmittance of less than 50%, thereby reducing transmittance of the light transmissive layer, or particles capable of adjusting transmittance may be added to a region of the light transmissive layer to block the light emitting device 130 from being visible from the outside.

In addition, the light transmissive layer may have a single layer structure to be disposed on a surface of the light emitting devices, as shown in FIG. 2 and FIG. 3, or may have a double layer structure to be disposed on both surfaces of the light emitting devices, as shown in FIG. 4. When the light transmissive layer 200 has the double layer structure, the film 100 interposed between two light transmissive layers 200 can be better protected and the length of the moisture permeation path can be increased to delay moisture permeation while improving reliability. In addition, a light emission direction may be adjusted to allow light to be emitted through a specific region through adjustment of the index of refraction or transmittance of the double light transmissive layer 200. The light transmissive layers 200 disposed on a first region and a second region of the light emitting device 130 may have different transmittances such that the light path can be adjusted to allow a greater quantity of light to be emitted through one surface of the light emitting devices. Here, the light transmissive layers 200 disposed on the first region and the second region of the light emitting device may include different materials. By way of example, a light transmissive layer 200 having low transmittance may further include a light scattering material, such as TiO₂, SiO₂, and the like, or a metallic material, such as Ag or Cr, to adjust light transmittance. Further, the light transmissive layers 200 disposed on the first region and the second region of the light emitting device 130 may have the same transmittance and may provide similar light intensity on a first surface and a second surface of the light emitting devices 130. In addition, the light transmissive layers 200 disposed on the first region and the second region of the light emitting device 130 may have different indices of refraction. By way of example, the light transmissive layer 200 disposed on the first region of the light emitting device 130 may have a lower index of refraction than the light transmissive layer 200 disposed on the second region thereof, and the intensity of light emitted through the light transmissive layer having a lower index of refraction on the first region of the light emitting devices may be higher than the intensity of light emitted through the light transmissive layer having a higher index of refraction on the second region thereof. The light transmissive layer 200 composed of a single layer is advantageous in terms of cost reduction.

The film 100 may be disposed on at least a region of the light emitting devices 130. The film 100 may be disposed on an upper region of the light transmissive layer 200 to protect an electrode 120, as shown in FIG. 2, may be disposed on a lower region of the light transmissive layer 200 to protect the light emitting devices 130, as shown in FIG. 3, or may be disposed between the two light transmissive layers 200 to adjust the light emission direction through effect of reflection or total reflection and to delay moisture permeation through increase in length of the moisture permeation path while improving reliability, as shown in FIG. 4. By way of example, in order to increase the effect of total reflection, a first light transmissive layer having an index of refraction of 1.6 or more may be disposed on one surface of the light emitting devices 130 and a second light transmissive layer having an index of refraction of 1.4 to 1.55 may be disposed on the other surface of the light emitting devices 130, thereby improving light extraction efficiency of the light path toward the first or second light transmissive layer through adjustment of the light path using a difference in index of refraction therebetween.

The film 100 includes a plurality of light emitting devices 130. Each of the light emitting devices 130 includes an N-type semiconductor layer, a P-type semiconductor layer, and an active layer interposed between the N-type semiconductor layer and the P-type semiconductor layer, and may emit light in the red, green, blue, cyan, or orange wavelength bands. The film may further include a wavelength conversion material to change the wavelength of light of the dominant wavelength of the light emitting device 130 to a desired color and a color filter to convert light generated in the light emitting device 130 to a desired color.

As shown in FIG. 1, the plurality of light emitting devices 130 may be arranged in N rows and M columns or in matrix form, in which the light emitting devices are arranged at regular intervals in longitudinal and transverse directions, whereby a digital image can be naturally expressed. The arrangement of the plurality of light emitting devices 130 is not limited thereto. For example, the plurality of light emitting devices 130 may be arranged in a diagonal or diamond shape to realize a natural image or may include zones with different spacing, as needed, to avoid interference with wiring or structures, thereby preventing deterioration in reliability due to interference or heat from the wiring or structures.

The film 100 may further include electrodes 120 on lower surfaces of the plurality of light emitting devices 130. The electrodes 120 are connected to an external power source to supply current to the plurality of light emitting devices 130. Preferably, the electrodes 120 are formed of a material having low electrical resistance to secure smooth current supply and may include at least one of iron, copper, tin, gold, silver, aluminum, metal compounds, metal oxides, graphite, graphene, or anisotropic conductive films.

In addition, the electrodes 120 may be formed corresponding to the arrangement of the light emitting devices 130 and may be formed as a mesh-shaped thin plate with horizontal rows and vertical columns corresponding to the arrangement of the light emitting devices 130 arranged in N rows and M columns. The electrode 120 may be a TFT electrode in which a thin film-shaped transistor, a data electrode, and a channel control electrode are formed, and may increase the degree of design freedom through reduction in thickness of the structure. The electrode 120 is not limited to the above embodiment and may be formed in various shapes, as needed.

The electrode 120 may provide a series circuit in which the plurality of light emitting devices 130 is connected in series or a parallel circuit in which the plurality of light emitting devices 130 is connected in parallel. Alternatively, the electrode 120 may provide a series-parallel circuit in which series connection regions of the plurality of light emitting devices 130 are connected in parallel or parallel connection regions of the plurality of light emitting devices 130 are connected in series. In addition, the electrodes 120 may further include transistors and capacitors and may adopt an active matrix addressing method to individually control the plurality of light emitting devices 130 by individually supplying current to the plurality of light emitting devices 130, or a passive matrix addressing method in which the plurality of light emitting devices 130 is operated by applying a voltage waveform to the plurality of light emitting devices 130 placed on cross electrodes or by switching. In addition, some of the electrode 120 may be a signal line through which input and output signals are applied or output to control operation of the light emitting devices 130.

The film 100 may have a structure in which the electrodes 120 are disposed on an upper surface of a base film 110 and the plurality of light emitting devices 130 is disposed on an upper surface of the electrodes 120. In addition, a molding layer 140 may be formed between the plurality of light emitting devices 130 and on top of the plurality of light emitting devices 130.

The molding layer 140 serves to protect the light emitting devices 130 and the electrodes 120, and may have a uniform height to ensure good adhesion to the light transmissive layer 200 disposed on an upper surface of the film 100. The molding layer 140 may be formed to partially surround only a region of the light emitting device 130 and can improve reliability by delaying moisture penetration through increase in length of the moisture penetration path. In addition, the molding layer 140 may include an adhesive material to increase adhesion. At least one surface of the molding layer may have higher adhesive strength than the light transmissive layer 200. The molding layer 140 may include materials, such as polyimide, epoxy molding compounds, silicone, and the like, and may be formed of a thermoplastic resin to havevarious shapes.

For the molding layer 140, a light emission angle can be adjusted or light extraction efficiency can be increased by adjusting the index of refraction of the molding layer 140. To increase light extraction efficiency of the molding layer 140, the molding layer 140 may have a lower index of refraction than the film 100. In addition, the molding layer 140 and the light transmissive layer 200 may have different indices of refraction to allow a greater quantity of light to be emitted through one side of the molding layer 140 and the light transmissive layer 200 through adjustment of the light path. The molding layer 140 may have a lower index of refraction than the light transmissive layer 200, as needed. Alternatively, the molding layer 140 may have a higher index of refraction than the light transmissive layer 200. In addition, the molding layer 140 may have a lower index of refraction than the light emitting devices 130 to improve light extraction efficiency by relieving variation in index of refraction. In addition, a low transmittance material, such as chromium, carbon pigments, iron tetroxide (Fe₃O₄), graphite, and the like, may be added to the molding layer 140 to improve visibility or color purity by controlling light to travel in a certain direction. In addition, pigments, such as BaSO₄, TiO₂, ZnO, 2PbCO₃·Pb(OH₂)₂, may be added to the molding layer 140 to increase reflectivity, thereby adjusting the light emission angle through reflection of light in a certain direction.

The molding layer 140 may include at least one of phosphor particles, quantum dots, organic dyes, or nonlinear optical converters for wavelength conversion in at least a region thereof and can realize a thin light emitting apparatus. By way of example, a first type particle may be a wavelength-conversion particle that emits light with a peak wavelength in the green or yellow wavelength band, and may include at least one of quantum dots, LuAG series, YAG series, β-SiAlON series, nitride series, silicate series, halo-phosphide series, or oxynitride series, without being limited thereto. A second type particle may include a red wavelength-conversion particle that emits light having a peak wavelength in the red wavelength band, and may include at least one of quantum dots, nitride series, such as CASN, CASON, SCASN, and the like, silicate series, sulfide series, or fluoride series, without being limited thereto.

The base film 110 is formed of a material having light transmittance that transmits light, and may be formed of a flexible material. The base film 110 may have a thickness of about 0.1 mm to 0.175 mm, and may be formed of a material, such as PET, PVB, or the like, and may be formed of a flexible material to increase the degree of design freedom. The base film 110 may be formed of an insulating material to reduce electrical interference between the electrodes 120, which will be described below. In addition, the base film 110 may be formed on one surface thereof with a light reflective region or a light absorption region to adjust the light emission path. By way of example, the light reflective region may be formed to increase reflectivity and not only a metallic reflective material, such as silver (Ag) or aluminum, but also a reflective pigment, such as BaSO₄, TiO₂, and 2PbCO₃·Pb(OH₂)₂ may be additionally disposed on the light reflective region. In addition, the light absorption region may be provided with a low transmittance material, such as chromium, carbon pigments, iron tetroxide (Fe₃O₄), graphite, and the like, which can absorb some fractions of light emitted through the corresponding region, thereby preventing glare or improving visibility.

The film 100 may have a total thickness of about 0.3 mm to about 1 mm, preferably about 0.35 mm to about 0.4 mm. The film 100 can increase light transmission through reduction in thickness thereof and can reduce the thickness of the light emitting apparatus, whereby the light emitting apparatus can be installed in a narrow space. However, when the thickness of the film 100 is reduced to 0.3 mm or less, durability may decrease. Accordingly, the film may have a thickness of 0.3 mm or more.

The film 100 may have a transmittance of 50% or more, preferably 80% or more. The electrodes 120 may occupy or cover 50% or less, preferably 20%, of the total area of the film. The electrode 120 may be formed of a material having light transmittance, such as TIO, ZnO, and the like, or a metallic material, such as Au, Cu, Fe, Al, Ag, and the like, formed in a thin layer to increase light transmittance. In addition, a wavelength converter may be formed on at least one surface of the film 100. The wavelength converter may include at least one of phosphor particles, quantum dots, organic dyes, or non-linear optical converters. The wavelength converter may include the same material as the wavelength conversion particles of the molding layer 140 described above. Alternatively, the molding layer 140 may include a different material than the wavelength converter or may include a material of lower concentration than the wavelength converter, as needed, without being limited thereto. In addition, the base film may be further provided in a region thereof with heat conductive fillers to dissipate heat generated from the light emitting devices 130, thereby improving reliability and stability through improvement of the heat dissipation structure.

A distance between adjacent light emitting devices 130 may be greater than a length or a width of each of the light emitting devices 130. When the distance between adjacent light emitting devices 130 is greater than the length or the width of each of the light emitting devices 130, the light emitting module can have an effect of reducing manufacturing costs while increasing the light transmittance of the film 100 through reduction in the number of light emitting devices 130. Furthermore, the light emitting devices 130 may have the same or similar lengths in the longitudinal and transverse directions thereof within a tolerance range in order to improve similarity of viewing angle in the longitudinal and transverse directions thereof.

Each of the light emitting devices 130 may have a length and/or a width of about 500 µm or less, preferably about 200 µm or less. Further, the light emitting devices 130 may be arranged at an interval of about 100 µm or more. A distance between adjacent light emitting devices 130 of the plurality of light emitting devices 130 may greater than a length or a width of each of the respective adjacent light emitting devices 130. The plurality of light emitting devices 130 may emit the same series of colors or different colors and each of the light emitting devices 130 may include sub-pixel devices that may emit different dominant wavelengths.

By way of example, when the light emitting module according to the present disclosure represents a brake lamp or an emergency lamp of an automobile, all of the plurality of light emitting devices 130 may emit a red series color. Furthermore, the light emitting module may include a plurality of light emitting devices 130, which emit red, green, and blue series light to realize various shapes, characters, emoticons, pictures, and the like. Further, the light emitting module according to the present disclosure may include a plurality of light emitting devices 130 emitting white light, wherein two or more of the plurality of light emitting devices 130 may emit white light having different color coordinates.

The plurality of light emitting devices 130 may be configured to be individually operated or may be divided into individually operated different regions.

The film 100 and the light transmissive layer 200 may differ from each other in terms of at least one among the index of refraction, gloss, thermal conductivity, and electrical conductivity. The different indices of refraction of the film 100 and the light transmissive layer 200 can result in total reflection effect of light, whereby the light emission path can be adjusted. In addition, when the film 100 is disposed on the light transmissive layer 200, as shown in FIG. 2, the film 100 may constitute a dominant light emission surface, may have higher luminous intensity measured thereon than luminous intensity measured on the light transmissive layer 200, and can protect the electrodes on the lower surface of the film 100 from external environmental fluctuation. Here, a light absorbing material or a light reflecting material may be deposited on one surface of the film to adjust the light path. Here, translucent treatment may be applied to one surface of the light transmissive layer 200. In addition, when the film 100 is disposed on the lower surface of the light transmissive layer 200, as shown in FIG. 3, the light transmissive layer 200 may constitute the dominant light emission surface, may have higher luminous intensity measured thereon than luminous intensity measured on the film 100, and can reduce damage to the light emitting devices 130 and the film from an external environment. When the film 100 is interposed between two light transmissive layers 200, as shown in FIG. 4, the light transmissive layer 200 disposed on one surface of the film may be formed to have higher transmittance than the light transmissive layer 200 on the other surface thereof to adjust the light path. In this case, luminous intensity measured on the light transmissive layer 200 with higher transmittance may be higher than luminous intensity measured on the other surface of the film. As such, when the film 100 is disposed between the two light transmissive layers 200, the film 100 can be protected from the external environment, thereby improving reliability of the light emitting module.

FIG. 5 to FIG. 7 are schematic views of a light emitting system according to one embodiment of the present disclosure. Referring to FIG. 5 to FIG. 7, the film 100 according to the present disclosure may be disposed over the entirety of a light transmissive layer 200 of the light emitting system, or may be disposed only in some regions thereof. The light emitting system according to the present disclosure may be installed in an automobile and the light transmissive layer 200 may be a rear windshield, without being limited thereto. Alternatively, the light emitting system according to the present disclosure may be applied to subway glass, bus glass, airplane windows, building exterior walls, building windows, outdoor advertisements, and the like. By way of example, the film 100 according to the present disclosure may be disposed on a window of a subway car to display subway map information through a plurality of light emitting devices 130.

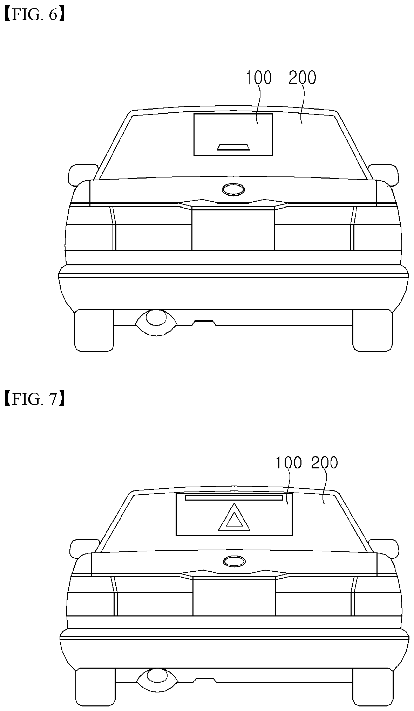

The light emitting module according to the present disclosure may represent an emergency lamp of an automobile through a triangular shape, as shown in FIG. 5, and may represent a brake lamp by allowing only the base line of the triangular shape represent the emergency lamp to emit light, as shown in FIG. 6. In this way, a light emitting region may be formed in a preset shape and each of the light emitting devices 130 may emit light in response to electrical signals to control the light emitting region such that light can be emitted from a region of the preset shape. By controlling the preset shape and the light emitting region in this way, various information can be represented with a small number of light emitting devices. Furthermore, as shown in FIG. 7, a region representing the emergency lamp and a region representing the brake lamp may be separately operated. Division of the operating regions in this way enables simultaneous or separate operation without interference between the regions.

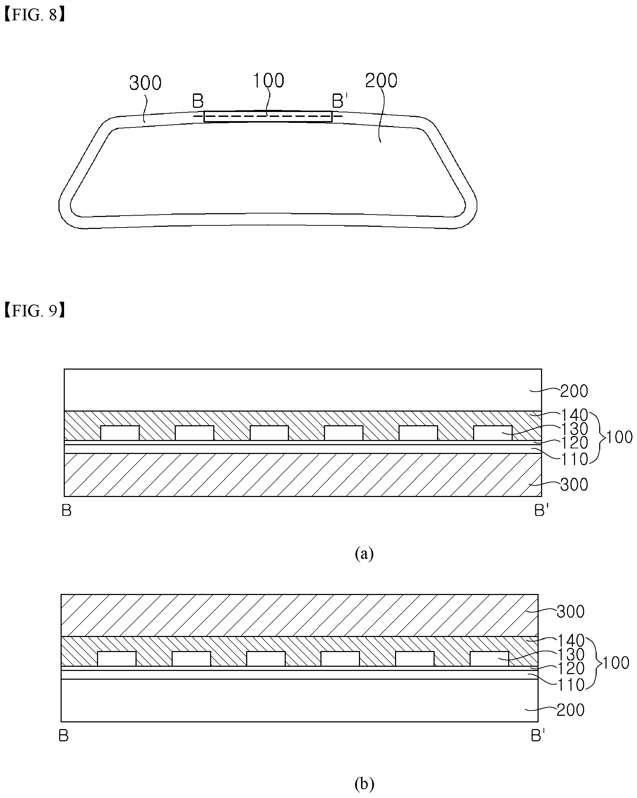

FIG. 8 is a schematic view of a light emitting system according to another embodiment of the present disclosure and FIG. 9 is a schematic sectional view of one embodiment of the light emitting system taken along line B-B' in FIG. 8.

Since brake lamps are more often turned on during driving of an automobile than emergency lamps, light emitted from the brake lamps and entering the automobile can be unpleasant to occupants. Accordingly, it may be necessary to reduce light transmittance in at least a region of the light emitting system, particularly in the brake lamps, so as to prevent light from entering the automobile.

FIG. 8 shows a rear windshield of an automobile by way of example, which may be provided with a low transmittance layer 300 in a region having low transmittance, such as a rim or sun visor of the rear windshield of the automobile. The low transmittance layer 300 may further include additives, such as Cr, C, Al, TiO2, BasO₄, SiO₂, and the like, and may reduce transmittance through a film, light-shielding coating, polarizing coating, reflective coating, and the like. The low transmittance layer 300 may have lower transmittance than the light transmissive layer 200 or the film 100, and may have a higher density of the additives per unit area than the light transmissive layer 200 or the film 100, in which the density of the additives per unit area can be estimated by the area or number of additives per unit area. The low transmittance layer 300 may have a transmittance of less than 50%, and may have a lower transmittance than the light transmissive layer 200 or the film 100. By way of example, the transmittance of the low transmittance layer 300 may be 50% or less of the transmittance of the light transmissive layer 200 or the film 100. The luminous intensity of light emitted through the low transmittance layer 300 may be less than 50% of the luminous intensity of light emitted through the light transmissive layer 200, thereby improving visibility through increase in quantity of light transmitted through the light transmissive layer 200.

Referring to FIG. 8 and FIG. 9, to prevent light emitted from the brake lamps of the automobile from entering the automobile, the film 100 may be at least partially disposed in a region on one surface of the low transmittance layer 300, the light transmissive layer 200 may be disposed on one surface of the film 100, the light emission direction may be adjusted to be directed toward the light transmissive layer 200, and the low transmittance layer 300 may be adjusted to reflect or absorb light. The low transmittance layer 300 and the light transmissive layer 200 may be disposed in different regions with reference to the film 100 to face each other through the film 100 and may be disposed in different phases in the vertical direction to overlap each other in at least a region in the vertical direction, when viewed in a cross-section. Here, light may be mainly emitted through one surface of the film 100, and, by way of example, the luminous intensity of light emitted from the light transmissive layer 200 may be at least 50% higher than the luminous intensity of light emitted from the lower light transmissive layer 300. In addition, as shown in FIG. 9(a), the low transmittance layer 300 may be disposed on one surface of the base film 110, a dominant light emission surface may face the light transmissive layer 200 through the molding layer 140, and a dominant light emission path may be formed in the light transmissive layer 200 having relatively high transmittance, thereby increasing the quantity of light through improvement in light extraction efficiency. Alternatively, as shown in FIG. 9(b), the low transmittance layer 300 may be disposed on one surface of the molding layer 140 and the dominant light emission surface may face the light transmissive layer 200 through the film 110, thereby preventing the molding layer 140 from being hydrolyzed by heat while improving reliability through improvement in structural stability.

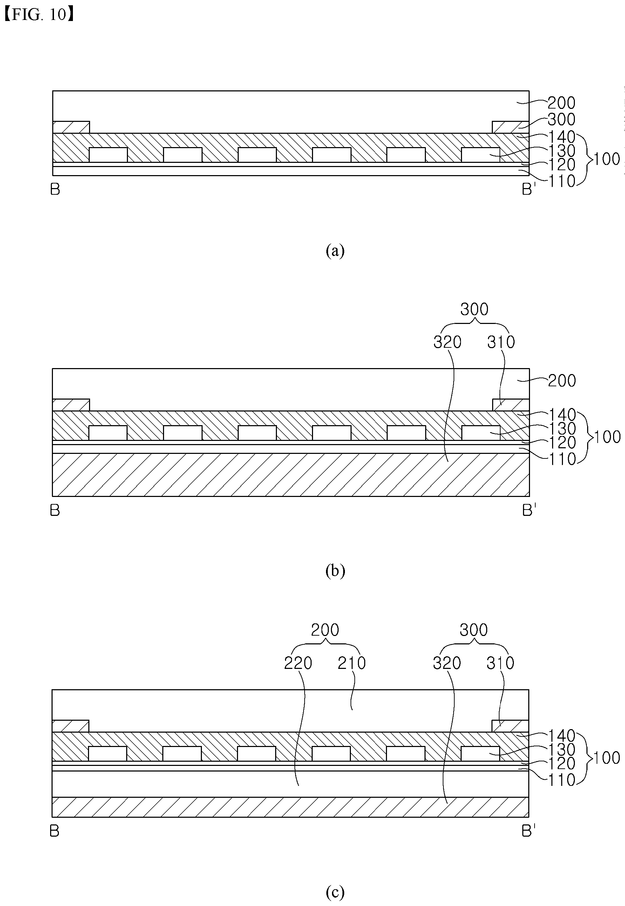

FIG. 10 is a schematic sectional view of another embodiment of the light emitting system taken along line B-B' in FIG. 8.

To reduce the quantity of light emitted from the light emitting system to some regions, a low transmittance layer 300 may be disposed in at least a region of the light transmissive layer 200, as shown in FIG. 10. The low transmittance layer 300 may adjust the light path by reflecting or absorbing light, as described with reference to FIG. 8 or FIG. 9.

As shown in FIG. 10(a), the low transmittance layer 300 may be disposed in a region of the light transmissive layer 200 and the film 100, may be disposed in a region of the light transmissive layer 200 and the film 100 to overlap the light transmissive layer 200 and/or the film 100 in the region thereof, and the film 100, the low transmittance layer 300, and the light transmissive layer 200 are arranged sequentially in the region in vertically cross-sectional view. The film 100 and the light transmissive layer 200 may be spaced apart from each other in the region by the low transmittance layer 300. This structure allows light to be mainly emitted through a region of the light transmissive layer 200 on which the low transmittance layer 300 is not disposed, and the quantity of emitted light and the light emission region may be adjusted such that the light transmissive layer 200 overlapping the low transmittance layer 300 has different luminous intensity than the light transmissive layer 200 not overlapping the low transmittance layer 300, in which a difference in luminous intensity of light emitted through the light transmissive layer 200 between a region of the light transmissive layer 200 overlapping the low transmittance layer 300 and a region of the light transmissive layer 200 not overlapping the low transmittance layer 300 may be 50% or more. On an upper surface of the light transmissive layer 200, the luminous intensity of the region of the light transmissive layer 200 not overlapping the low transmittance layer 300 may be at least 50% higher than the luminous intensity of the region of the light transmissive layer 200 overlapping the low transmittance layer 300. The light emitting system may have regions with different luminous intensity at a certain distance. The low transmittance layer 300 may have a different thickness from the light transmissive layer 200. The region of the light transmissive layer 200 overlapping the low transmittance layer 300 may have a lower thickness than the region of the light transmissive layer 200 not overlapping the low transmittance layer 300.

As shown in FIG. 10(b), the low transmittance layer 300 may be disposed on each of the upper and lower surfaces of the film 100, and may include a first low transmittance layer 310 disposed on one surface of the film 100 and a second low transmittance layer 320 disposed on the other surface of the film 100. Here, the low transmittance layer 300 and the light transmissive layer 200 may be the same as those described above with reference to FIG. 10(a). The first low transmittance layer 310 and the second low transmittance layer 320 may be disposed on one surface and the other surface of the film 100 in a region of the film 100 to overlap each other and may be spaced apart from each other by the film 100. In addition, at least one of the first low transmittance layer 310 disposed on the one surface of the film 100 and the second low transmittance layer 320 disposed on the other surface of the film 100 may include an open region that is not continuous and is broken, and the first low transmittance layer 310 and the second low transmittance layer 320 may not vertically overlap each other in a region thereof. The second low transmittance layer 320, the film 100, the first low transmittance layer 310, and the light transmissive layer 200 may be arranged sequentially in a region thereof in vertically cross-sectional view, and the second low transmittance layer 320, the film 100, and the light transmissive layer 200 may be arranged sequentially without the first low transmittance layer 310 in a region thereof in vertically cross-sectional view. Light may be mainly emitted through the light transmissive layer 200 in the open region where the first low transmittance layer 310 is not disposed, and may be less emitted through the first low transmittance layer 310 or the second low transmittance layer 320. Here, a difference in luminous intensity of light emitted through the light transmissive layer 200 between a region of the light transmissive layer 200 overlapping the first low transmittance layer 310 and a region of the light transmissive layer 200 not overlapping the first low transmittance layer 310 may be 50% or more, and a difference in luminous intensity of emitted light between the region of the light transmissive layer 200 not overlapping the first low transmittance layer 310 and the second low transmittance layer 320 may be 50% or more, thereby enabling adjustment of an illumination region. In addition, regions of the low transmittance layer 300 disposed on one surface of the film 100 and the other surface of the film 100 may have the same luminous intensity, thereby preventing light leakage while improving visibility. In addition, the first low transmittance layer 310 and the second low transmittance layer 320 respectively disposed on the one surface of the film 100 and the other surface of the film 100 may have different transmittances, and may have different thicknesses, and may be adjusted to emit a greater quantity of light through one surface. Without being limited thereto, the first low transmittance layer 310 and the second low transmittance layer 320 may have the same transmittance in at least a region thereof, and may have the same thickness, and may be adjusted to emit the same quantity of light, whereby the film 100 can have similar luminous intensity on both surfaces thereof in at least a region thereof.

A second light transmissive layer 220 may be further disposed between the film 100 and the first low transmittance layer 310 and/or between the film 100 and the second low transmittance layer 320, as shown in FIG. 10(c). In a region of the film 100, the first light transmissive layer 210 and the second light transmissive layer 220 may be disposed on one surface and the other surface of the film 100, respectively, and the first low transmittance layer 310 may be disposed in a region of the first light transmissive layer 210. Here, a difference in luminous intensity of light emitted through the first light transmissive layer 210 between a region of the first light transmissive layer 210 overlapping the first low transmittance layer 310 and a region of the first light transmissive layer 210 not overlapping the first low transmittance layer 310 may be 50% or more, and a difference in luminous intensity of emitted light between the region of the first light transmissive layer 210 not overlapping the first low transmittance layer 310 and the second low transmittance layer 320 may be 50% or more, thereby enabling adjustment of an illumination region. A region of the first low transmittance layer 310 and a region of the second low transmittance layer 310 may have the same luminous intensity, thereby preventing light leakage while improving visibility. In addition, the first low transmittance layer 310 and the second low transmittance layer 320 may have different transmittances in at least a region thereof, and may have different thicknesses, and may be adjusted to emit a greater quantity of light through one surface. The second low transmittance layer 320 may also be spaced apart from the film 100 by the second light transmissive layer 220 to increase the length of the moisture permeation path, thereby improving moisture permeability while improving reliability. The first light transmissive layer 210 and the second light transmissive layer 220 may be disposed on one surface and the other side of the film 100 to overlap each other and may be spaced apart from each other by the film 100 in the vertical direction. The first low transmittance layer 310 disposed on one surface of the film 100 may overlap the second low transmittance layer 220 disposed on one surface of the second light transmissive layer 220 in a region thereof in the vertical direction. Further, the first low transmittance layer 310 of the low transmittance layer 300 disposed on one surface of the film 100 may include an open region, and the first low transmittance layer 310 and the second low transmittance layer 320 may not vertically overlap each other in a region thereof. The first light transmissive layer 210, the first low transmittance layer 310, the film 100, the second light transmissive layer 220, and the second low transmittance layer 320 may be arranged sequentially in a region thereof in vertically cross-sectional view, and the first light transmissive layer 210, the film 100, the second light transmissive layer 220, and the second low transmittance layer 320 may be arranged sequentially in a region thereof in vertically cross-sectional view, whereby the region of the first light transmissive layer 210 not provided with the first low transmittance layer 310 can have high luminous intensity. Furthermore, the second low transmittance layer 320 is disposed outside the second light transmissive layer 220 and is spaced apart from the light emitting devices 130 by the second light transmissive layer 220 to diversify the light path, thereby enabling uniform emission of light through refraction and reflection of the light. A difference in luminous intensity of light emitted through the first light transmissive layer 210 between the region of the first light transmissive layer 210 overlapping the first low transmittance layer 310 and the region of the first light transmissive layer 210 not overlapping the first low transmittance layer 310 may be 50% or more, and a difference in luminous intensity of emitted light between the region of the first light transmissive layer 210 not overlapping the first low transmittance layer 310 and the second low transmittance layer 320 may be 50% or more. In addition, the first low transmittance layer 310 and the second low transmittance layer 320 disposed on one surface and the other side of the film 100 may have the same luminous intensity in a region thereof, thereby improving the effect of preventing light leakage. Alternatively, the first low transmittance layer 310 and the second low transmittance layer 320 disposed on one surface and the other surface of the film 100 may have different transmittances in a region thereof, and may be adjusted to emit a greater quantity of light through one surface by having different luminous intensity, thereby preventing light leakage while securing backward visibility.

Referring to FIG. 9 and Fig. 10, a heat dissipation film or pad may be added in a region of the low transmittance layer 300 to dissipate heat generated from the light emitting device 130, thereby improving reliability of the light emitting system.

The electrode 120 of the light emitting module may extend to the rim of the light transmissive layer 200 and may be connected to an external power source.

By way of example, when the light transmissive layer 200 is implemented on a rear windshield of an automobile, and the like, the light transmissive layer 200 may have a heating wire or an antenna in a region thereof. Here, when the light emitting device 130 is disposed to overlap the heating wire or the antenna, the light emitting devices 130 can be damaged by heat or interference. Therefore, the light emitting devices 130 may be arranged to avoid a region in which the heating wire is disposed, and thus may be arranged at different intervals in a region thereof. In addition, an insulation layer may be added to reduce damage to the light emitting devices 130 by heat generated from the heating wire. In addition, a heat dissipation layer may be further disposed to dissipate heat generated by the light emitting devices 130.

According to the present disclosure, the light emitting system can display certain shapes, characters, emoticons, pictures, and the like through the light emitting devices 130, only when needed, while maintaining transparency when the light emitting devices 130 are not turned on.

According to one embodiment of the present disclosure, the light emitting system is configured to realize shapes, characters, emoticons, pictures, and the like in various color combinations on a rear windshield of an automobile to enable communication between drivers. In addition, without being limited thereto, the light emitting system may be arranged on the windshield, side windows, side mirrors, and the like to display information to the driver. Furthermore, the light emitting system may also be disposed on building exteriors, such as windows and glass doors, or on exterior glass, thereby applying to signage, digital information displays (DID), and the like.

In addition, the light emitting system according to the present disclosure may be applied not only to automobiles but also to various other places composed of plates with light transmittance, such as glass and the like.

Although some embodiments have been described herein, it should be understood by those skilled in the art or a person having ordinary knowledge in the art that various modifications, variations and alterations can be made without departing from the scope of the disclosure.

Therefore, it should be understood that the scope of the disclosure is not limited the above embodiments and is defined only by the appended claims and equivalents thereto.

### [List of Reference Numerals]

| | | | |
|---|---|---|---|
| 100: | Film | 110: | Base film |
| 120: | Electrode | 130: | Light emitting device |
| 140: | Molding layer | 200: | Light transmissive layer |
| 300: | Low transmittance layer | | |

## Claims

1. A light emitting module comprising:
a light transmissive layer;
a film disposed on at least a region of the light transmissive layer;
an electrode layer disposed on the film; and
a plurality of light emitting devices disposed on the film and electrically connected to the electrode layer,
where in the electrode layer cover 50% or less of an extent of the base film.

2. The light emitting module according to claim 1, wherein the film comprises an electrode formed as a mesh-shaped thin plate and supplying current to the plurality of light emitting devices.

3. The light emitting module according to claim 1 or 2, wherein the light transmissive layer is formed in a double structure and the film is disposed between two light transmissive layers.

4. The light emitting module according to any of claims 1 to 3, wherein the light emitting devices are disposed at regular intervals.

5. The light emitting module according to any of claims 1 to 4, wherein the light emitting module includes a section where intervals of light emitting devices are different.

6. The light emitting module according to any of claims 1 to 5, wherein the film and the light transmissive layer differ from each other in terms of at least one of an index of refraction, gloss, thermal conductivity, or electrical conductivity.

7. The light emitting module according to any of claims 1 to 6, wherein the film has a light transmittance of 50% or more.

8. The light emitting module according to any of claims 1 to 7, wherein the electrode extends to a rim of the light transmissive layer to be connected to an external power source.

9. The light emitting module according to any of claims 1 to 8, wherein the plurality of light emitting devices is configured to be individually operated or is divided into individually operated different regions.

10. The light emitting module according to any of claims 1 to 9, wherein a distance between adjacent light emitting devices of the plurality of light emitting devices is greater than a length or a width of each of the respective adjacent light emitting devices.

11. A light emitting module comprising:
a film comprising a base film, an electrode disposed on the base film, and a plurality of light emitting devices disposed on the electrode,
wherein the base film has light transmittance and the light emitting module is configured to display at least one of shapes, characters, emoticons, or pictures through the plurality of light emitting devices.

12. The light emitting module according to claim 11, wherein the base film has flexibility.

13. The light emitting module according to claim 11 or 12, further comprising:
at least one light transmissive layer,
wherein the film is disposed on at least a region of the light transmissive layer.

14. The light emitting module according to any of claims 11 to 13, further comprising:
a molding layer formed on the plurality of light emitting devices.

15. The light emitting module according to claim 1, disposed on a light emitting system,
the light emitting system comprising:
a film comprising a base film, an electrode disposed on the base film, and a plurality of light emitting devices disposed on the electrode,
wherein the base film has light transmittance and the light emitting module displays at least one of shapes, characters, emoticons, or pictures through the plurality of light emitting devices.
